# EUROPEAN PATENT SPECIFICATION

(11) **EP 4 340 010 B1**
(45) Date of publication and mention of the grant of the patent: **25.06.2025**
(21) Application number: 21949634.6
(22) Date of filing: 14.07.2021
(51) Int. Cl.: H01L 23/31, H01L 23/40, H01L 23/473, H01L 23/00

(54) **CHIP PACKAGING STRUCTURE AND PACKAGING METHOD AND ELECTRONIC DEVICE**
CHIPGEHÄUSESTRUKTUR UND VERPACKUNGSVERFAHREN UND ELEKTRONISCHE VORRICHTUNG
STRUCTURE D'ENCAPSULATION DE PUCE ET PROCÉDÉ D'ENCAPSULATION ET DISPOSITIF ÉLECTRONIQUE

(43) Date of publication of application: 20.03.2024
(73) Proprietor: Huawei Technologies Co., Ltd., Shenzhen, Guangdong 518129 (CN)
(72) Inventor: SU, Yu, Shenzhen, Guangdong 518129 (CN); LU, Jianbiao, Shenzhen, Guangdong 518129 (CN); CHEN, Xiaodan, Shenzhen, Guangdong 518129 (CN); ZHENG, Jiantao, Shenzhen, Guangdong 518129 (CN)
(74) Representative: Körber, Martin Hans
(86) International application number: PCT/CN2021/106344
(87) International publication number: WO 2023/283842

(56) References cited:
- WO-A1-2021/119930
- CN-A- 1 885 528
- CN-A- 108 933 108
- CN-A- 110 197 793
- CN-U- 211 208 425
- US-A1- 2009 316 360
- US-A1- 2010 148 358
- US-A1- 2018 342 466
- US-A1- 2019 287 931
- US-A1- 2021 098 335
- US-A1- 2021 159 139

## Description

### TECHNICAL FIELD

This application relates to the field of microelectronic technologies, and in particular, to a chip package structure, a packaging method, and an electronic device.

### BACKGROUND

A chip with high power consumption, for example, a chip in a flip chip ball grid array (FCBGA) packaging form, generates much heat in a working process. Most of the heat is conducted to a back side of the chip, and the heat is dissipated from the back side of the chip.

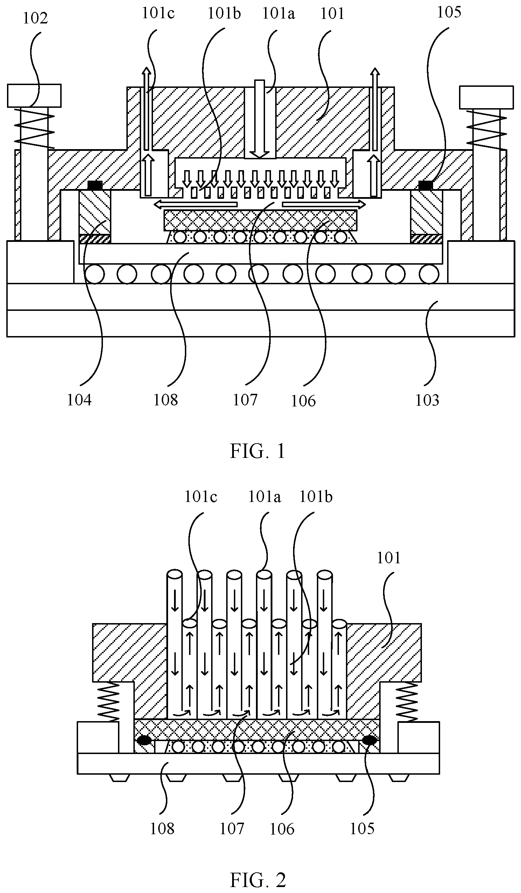

Currently, a liquid cooling manner may be used for heat dissipation. As shown in FIG. 1, FIG. 2, and FIG. 3, in a liquid cooling based heat dissipation solution, a refrigerating apparatus 101 is fastened to a printed circuit board (printed circuit board, PCB) 103 by using a spring screw 102, and an accommodation cavity 107 is formed between a chip 106 and the refrigerating apparatus 101 by using a supporting part 104 and a sealing kit 105. A cooling medium enters the accommodation cavity 107 from a liquid inlet 101a and a sprinkler-shaped flow channel 101b to perform heat exchange with the chip, and flows out of the accommodation cavity 107 from a liquid return port 101c.

However, in the foregoing solution, the chip 106 needs to be in direct contact with the cooling medium. As shown in FIG. 1, the cooling medium exists on an upper surface of the chip 106 and in the accommodation cavity 107 on a side surface of the chip 106. After an adhesive layer between the supporting part 104 and a substrate 108 is in contact with the cooling medium, the adhesive layer is prone to failure. In addition, an underfill adhesive between the chip 106 and the substrate 108 has a risk of cooling medium penetration. In structures shown in FIG. 2 and FIG. 3, the cooling medium may penetrate into the chip 106 from the back of the chip 106. In conclusion, the foregoing chip package structures all have a problem of low waterproof performance.

In addition, in the structures shown in the foregoing solution, the substrate is more greatly deformed than the chip, and the substrate is prone to warping. Document US 2021/159139 A1 describes a semiconductor device including a substrate, a semiconductor package, a plurality of pillars and a lid is provided. Document US 2021/098335 A1 describes a package structure including a wafer-form semiconductor package and a thermal dissipating system. Document WO 2021/119930 A1 describes a chip package and a fabrication method therefor used to mitigate the deformation of a heat dissipation sheet caused by the deformation of a substrate. Document CN 108933108 A describes semiconductor device package including a substrate, a semiconductor chip, a first ring structure and asecond ring structure, and a method of manufacturing the same. Document US 2009/316360 A1 describes a cooling apparatus and method of fabrication for facilitating removal of heat from a heat-generating electronic device. Document US 2010/148358 A1 describes a semiconductor device having a higher thermal dissipation efficiency includes a thermally conducting structure attached to a surface of the semiconductor device via soldering.

### SUMMARY

Embodiments of this application provide a chip package structure, a packaging method, and an electronic device, to resolve a problem of low waterproof performance of a chip.

To achieve the foregoing objective, this application uses the following technical solutions.

According to a first aspect, a chip package structure is provided. The chip package structure includes: a substrate; a chip, having a first surface close to the substrate and a second surface opposite to the first surface; a first pin layer, including a plurality of first pins disposed between the first surface of the chip and the substrate; a molding part, disposed on a periphery of the chip and the first pin layer, where a surface that is of the molding part and that is away from the substrate is higher than the first surface of the chip, and covers a side surface of the first pin layer and at least a part of a side surface of the chip, and the molding part is attached to the side surface of the chip; and a waterproof layer, disposed on the second surface of the chip and the surface that is of the molding part and that is away from the substrate.

Based on the chip package structure provided in the first aspect, the molding part is disposed on the periphery of the chip and the first pin layer, and the waterproof layer is disposed on the surface that is of the molding part and that is away from the substrate and the second surface of the chip, so that the molding part can prevent a refrigerating medium from penetrating into the first pin layer or the chip from the side surface of the first pin layer and the side surface of the chip, and the waterproof layer can prevent the refrigerating medium from penetrating into the chip from a surface of the chip and prevent the refrigerating medium from penetrating into the chip from the molding part, to improve waterproof performance of the chip, and improve reliability of the chip.

In addition, the molding part is disposed on the substrate. Because the molding part has a large modulus and cannot be easily deformed, deformation of the substrate may be limited when the substrate warps, to reduce a warping degree of the substrate. This reduces circuit faults caused by deterioration in the waterproof performance and poor contact.

In a possible design solution, the molding part covers all side surfaces of the chip, and the surface that is of the molding part and that is away from the substrate may be flush with the second surface of the chip. In other words, a distance between the surface that is of the molding part and that is away from the substrate and the substrate is equal to a distance between the second surface of the chip and the substrate. In this way, refrigerating media that penetrate into the chip from the side surface of the chip may be further reduced, and the waterproof performance is further improved. In addition, the molding part covers all the side surfaces of the chip, and when an edge of the chip is squeezed by an external force, the molding part can implement a buffering function, to better protect the chip and further improve the reliability. In addition, the surface that is of the molding part and that is away from the substrate is flush with the second surface of the chip, so that the waterproof layer can be easily processed.

In a possible design solution, the surface that is of the molding part and that is away from the substrate may be lower than the second surface of the chip. In other words, the distance between the surface that is of the molding part and that is away from the substrate and the substrate is less than the distance between the second surface of the chip and the substrate. In this way, in a process of forming the molding part, raw materials of the molding part flowing to the second surface of the chip may be reduced, and a surface of a chip is not covered by a molding part 404, to reduce raw material grinding processes for the molding part of the second surface of the chip, and improve efficiency. In addition, an upper half part of the side surface of the chip is not covered by the molding part, so that heat dissipation can be implemented, and heat dissipation efficiency can be improved.

In a possible design solution, the chip package structure may further include: a supporting part, disposed on the substrate. The supporting part surrounds the molding part, and an outer side surface of the molding part is attached to an inner side surface of the supporting part. In this way, pressure may be applied to an edge of the substrate by using the supporting part, to reduce the warping degree of the substrate. This reduces the circuit faults caused by the deterioration in the waterproof performance and the poor contact. In addition, the refrigerating medium can be prevented from penetrating into the chip from the outer side surface of the molding part, to further improve waterproof effect.

A surface that is of the supporting part and that is away from the substrate is higher than the second surface of the chip. In other words, a distance between the surface that is of the supporting part and that is away from the substrate and the substrate may be greater than the distance between the second surface of the chip and the substrate. In this way, pressure can be better applied to the substrate by using the supporting part, to further reduce the warping degree of the substrate. This further reduces the circuit faults caused by the deterioration in the waterproof performance and the poor contact.

Alternatively, optionally, a surface that is of the supporting part and that is away from the substrate may be lower than the second surface of the chip. In other words, a distance between the surface that is of the supporting part and that is away from the substrate and the substrate may be less than the distance between the second surface of the chip and the substrate. In this way, operations, for example, grinding the molding part or the chip, can be more conveniently performed, to improve efficiency.

In a possible design solution, the chip package structure may further include: a refrigerating apparatus, including a liquid inlet, a liquid return port, and a sprinkler-shaped flow channel. An accommodation cavity for accommodating a refrigerant is formed between the sprinkler-shaped flow channel, the liquid return port, and the waterproof layer, and the accommodation cavity covers at least the waterproof layer corresponding to the second surface of the chip. The liquid inlet is in communication with the sprinkler-shaped flow channel, the sprinkler-shaped flow channel is in communication with the accommodation cavity, and the accommodation cavity is in communication with the liquid return port. In this way, the accommodation cavity formed between the refrigerating apparatus and the chip may completely cover areas that are on the waterproof layer and that correspond to the second surface of the chip. In this way, heat dissipation can be implemented on the second surface of the chip, and pins may be arranged in all the areas corresponding to the second surface, without a limitation. In addition, a sealing force is applied outside the second surface of the chip to reduce a risk that the chip is damaged by an external force. This ensures the waterproof performance, heat dissipation efficiency, and the reliability.

According to a second aspect, an electronic device is provided. The electronic device includes a printed circuit board and at least one chip package structure according to any design solution of the first aspect, and the chip package structure is connected to the printed circuit board. The electronic device provided in the second aspect has a same technical effect as the chip package structure provided in the first aspect. Details are not described herein again.

For example, the electronic device according to the second aspect may include an electronic product such as a server or a super computer. It may be understood that the electronic device may further include an electronic product used for industrial control, an electronic product of a data center, or the like.

According to a third aspect, a chip packaging method is provided. The chip packaging method includes: forming, on a substrate, a molding part that surrounds a chip, where the chip is disposed on the substrate, the chip has a first surface close to the substrate and a second surface opposite to the first surface, the first surface is connected to the substrate through a first pin layer, the first pin layer includes a plurality of first pins disposed between the first surface of the chip and the substrate, a surface that is of the molding part and that is away from the substrate is higher than the first surface of the chip, the molding part covers a side surface of the first pin layer and at least a part of a side surface of the chip, and the molding part is attached to the side surface of the chip; and forming a waterproof layer on the second surface of the chip and the surface that is of the molding part and that is away from the substrate.

In a possible design solution, the molding part covers all side surfaces of the chip, and the surface that is of the molding part and that is away from the substrate may be flush with the second surface of the chip.

In a possible design solution, the surface that is of the molding part and that is away from the substrate may be lower than the second surface of the chip.

In a possible design solution, before the forming, on a substrate, a molding part that surrounds a chip, the chip packaging method may further include: forming, on a periphery of the chip, an enclosure dam for limiting the molding part. The enclosure dam is located on the substrate. The forming, on a substrate, a molding part that surrounds a chip may include: forming the molding part between the enclosure dam and the chip.

Optionally, the enclosure dam may be a supporting part, and an outer side surface of the molding part is attached to an inner side surface of the supporting part.

Further, a surface that is of the supporting part and that is away from the substrate is higher than the second surface of the chip.

Alternatively, further, the surface that is of the supporting part and that is away from the substrate may be lower than the second surface of the chip.

In a possible design solution, before the forming, on a substrate, a molding part that surrounds a chip, the chip packaging method may further include: connecting the substrate to a printed circuit board.

In a possible design solution, after the forming a waterproof layer on the second surface of the chip and the surface that is of the molding part and that is away from the substrate, the chip packaging method may further include: connecting the substrate to a printed circuit board.

The chip packaging method in the third aspect and the chip packaging structure provided in the first aspect have a same technical effect. Details are not described herein again.

### BRIEF DESCRIPTION OF DRAWINGS

FIG. 1 is a schematic diagram 1 of a cross-sectional structure of a chip package structure according to a conventional technology;
FIG. 2 is a schematic diagram 2 of a cross-sectional structure of a chip package structure according to a conventional technology;

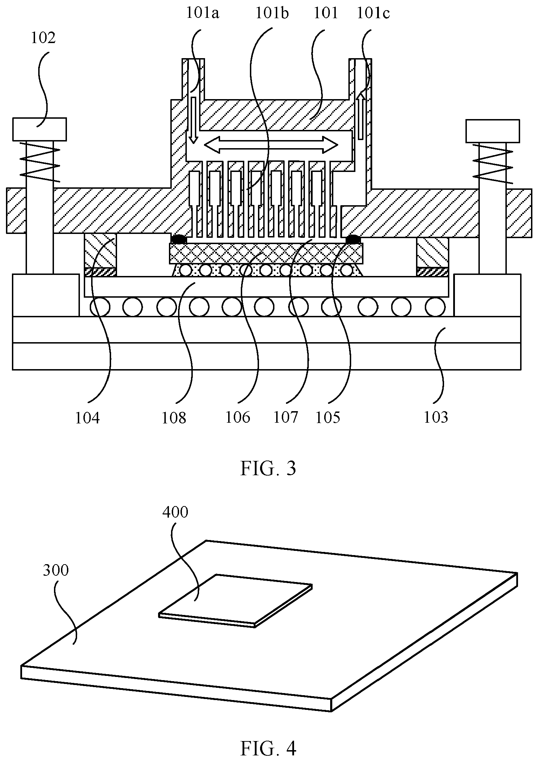

FIG. 3 is a schematic diagram 3 of a cross-sectional structure of a chip package structure according to a conventional technology;
FIG. 4 is a schematic diagram of a structure of an electronic device according to an embodiment of this application;

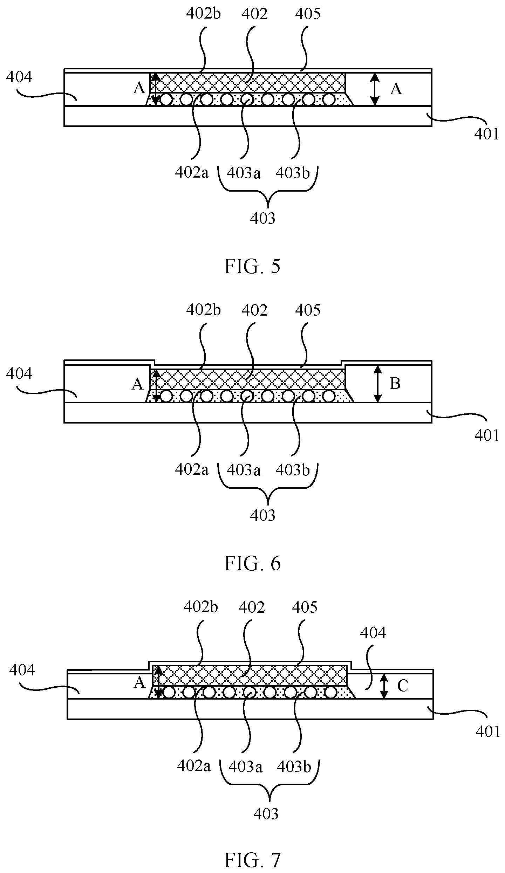

FIG. 5 is a schematic diagram 1 of a cross-sectional structure of a chip package structure according to an embodiment of this application;
FIG. 6 is a schematic diagram 2 of a cross-sectional structure of a chip package structure according to an embodiment of this application;
FIG. 7 is a schematic diagram 3 of a cross-sectional structure of a chip package structure according to an embodiment of this application;

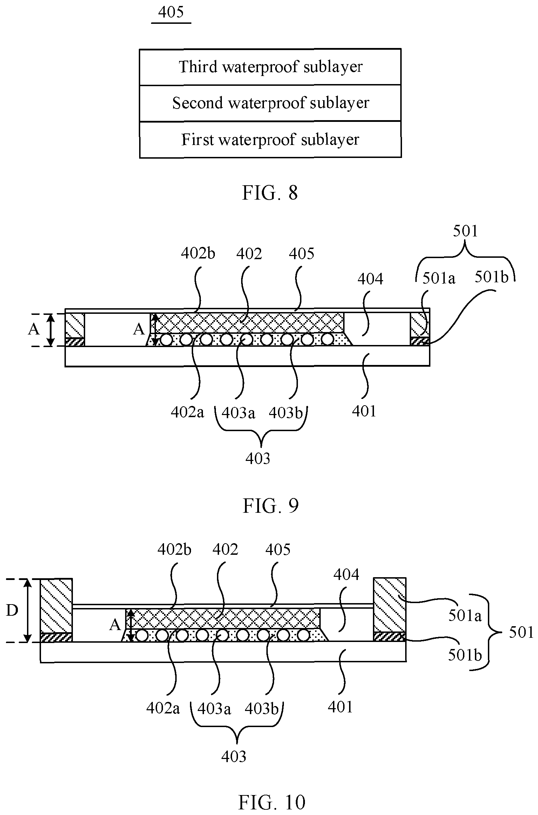

FIG. 8 is a schematic diagram of a structure of a waterproof layer according to an embodiment of this application;
FIG. 9 is a schematic diagram 4 of a cross-sectional structure of a chip package structure according to an embodiment of this application, which is not encompassed by the subject-matter of the claims but considered useful for understanding the invention;
FIG. 10 is a schematic diagram 5 of a cross-sectional structure of a chip package structure according to an embodiment of this application;

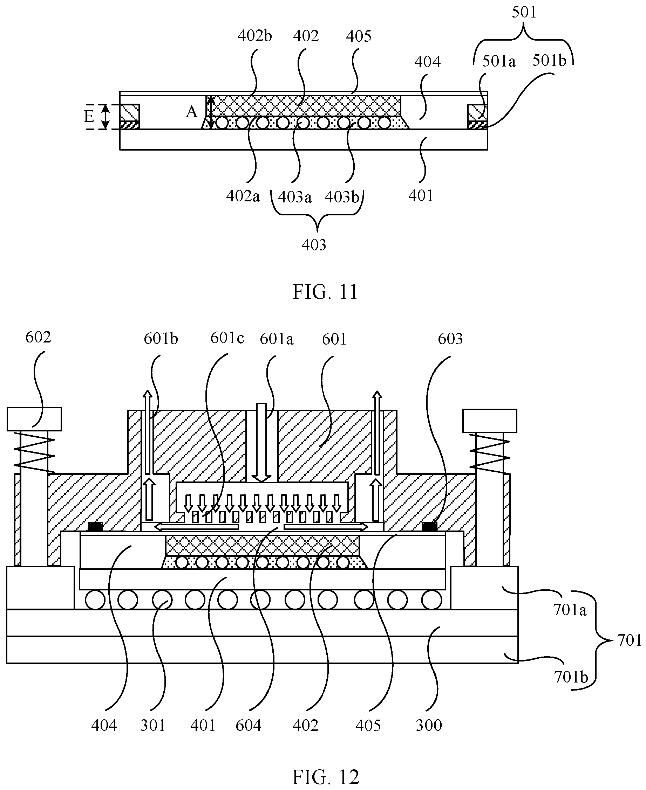

FIG. 11 is a schematic diagram 6 of a cross-sectional structure of a chip package structure according to an embodiment of this application, which is not encompassed by the subject-matter of the claims but considered useful for understanding the invention;
FIG. 12 is a schematic diagram 7 of a cross-sectional structure of a chip package structure according to an embodiment of this application, which is not encompassed by the subject-matter of the claims but considered useful for understanding the invention;

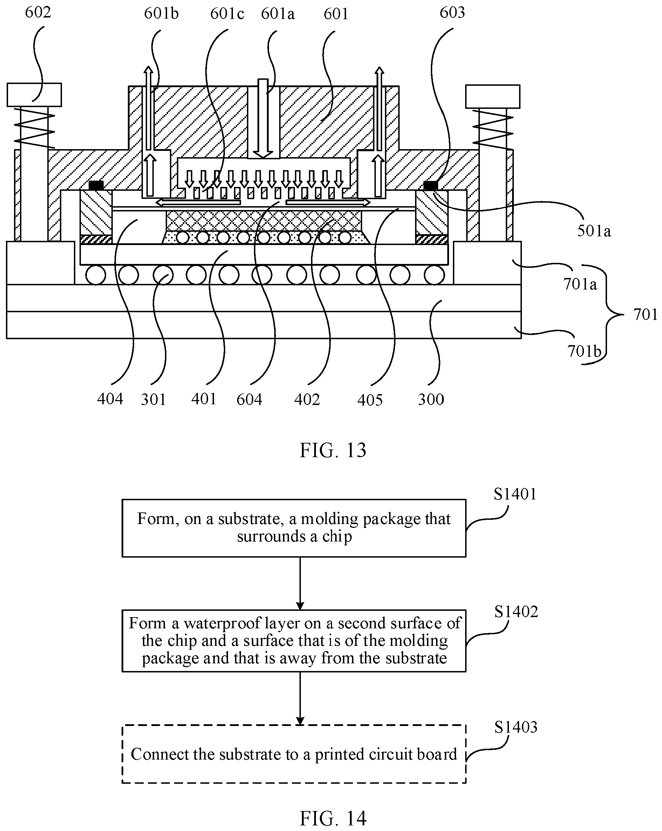

FIG. 13 is a schematic diagram 9 of a cross-sectional structure of a chip package structure according to an embodiment of this application;
FIG. 14 is a schematic flowchart 1 of a chip packaging method according to an embodiment of this application;

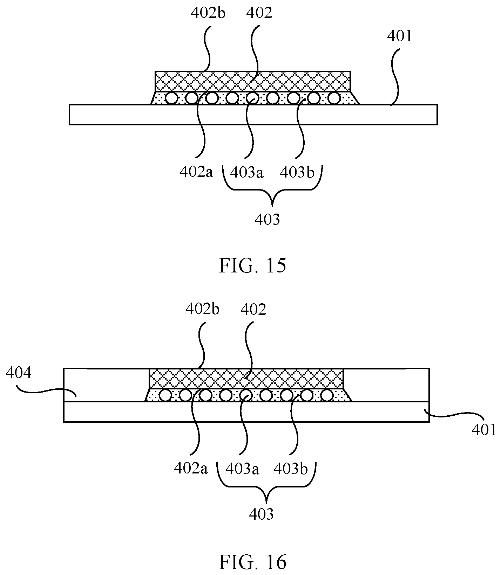

FIG. 15 is a schematic diagram of a connection structure between a chip and a substrate according to an embodiment of this application;
FIG. 16 is a schematic diagram 1 of a structure formed by performing S1401 in FIG. 14 according to example 1, which is not encompassed by the subject-matter of the claims but considered useful for understanding the invention;

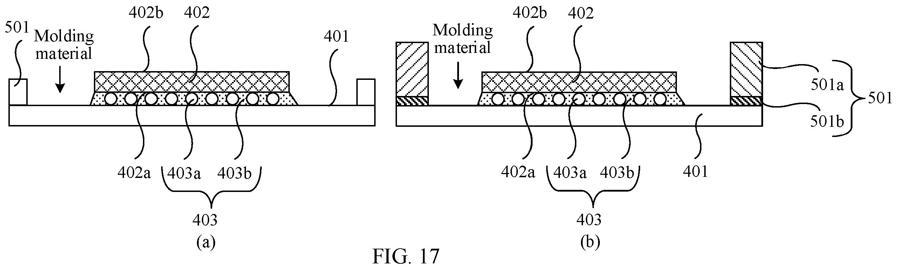

FIG. 17 is a schematic diagram of a structure formed by performing step 1 according to example 1;

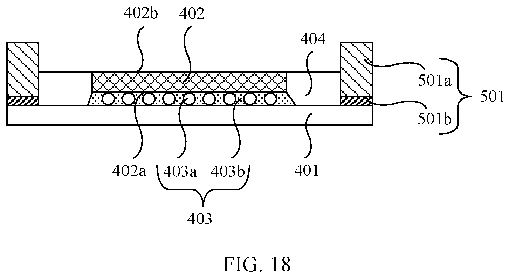

FIG. 18 is a schematic diagram 2 of a structure formed by performing S1401 in FIG. 14 according to example 1;

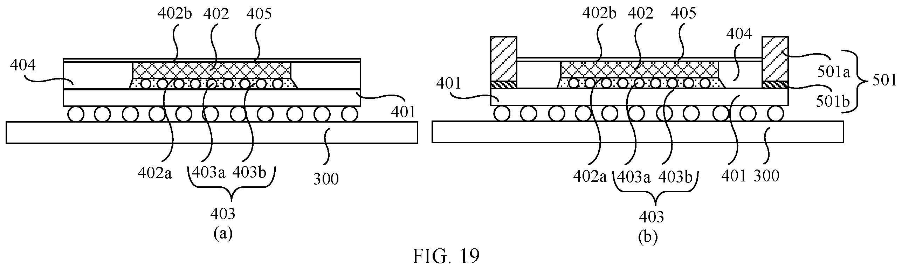

FIG. 19 is a schematic diagram of a structure formed by performing S1402 in FIG. 14 according to example 1, whose figure (a) is not encompassed by the subject-matter of the claims but considered useful for understanding the invention;

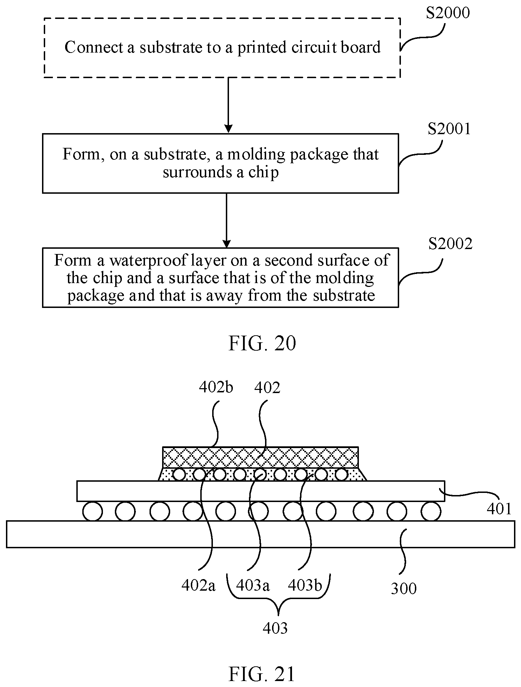

FIG. 20 is a schematic flowchart 2 of a chip packaging method according to an embodiment of this application;
FIG. 21 is a schematic diagram of a structure of a chip in an initial state that performs FIG. 20 according to example 2, which is not encompassed by the subject-matter of the claims but considered useful for understanding the invention;

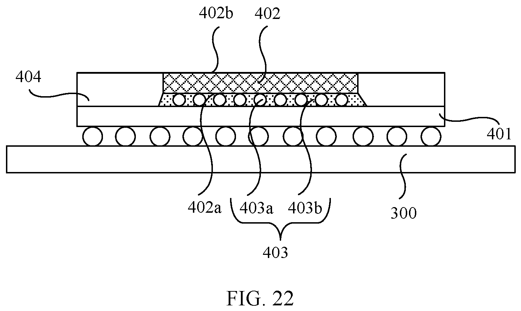

FIG. 22 is a schematic diagram 1 of a structure formed by performing S2001 in FIG. 20 according to example 2, which is not encompassed by the subject-matter of the claims but considered useful for understanding the invention;

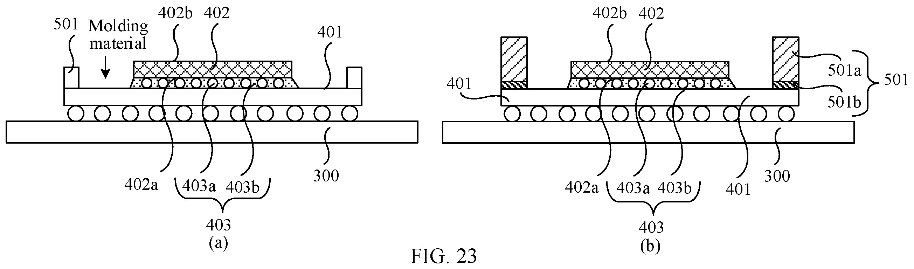

FIG. 23 is a schematic diagram of a structure formed by performing step 4 according to example 2;

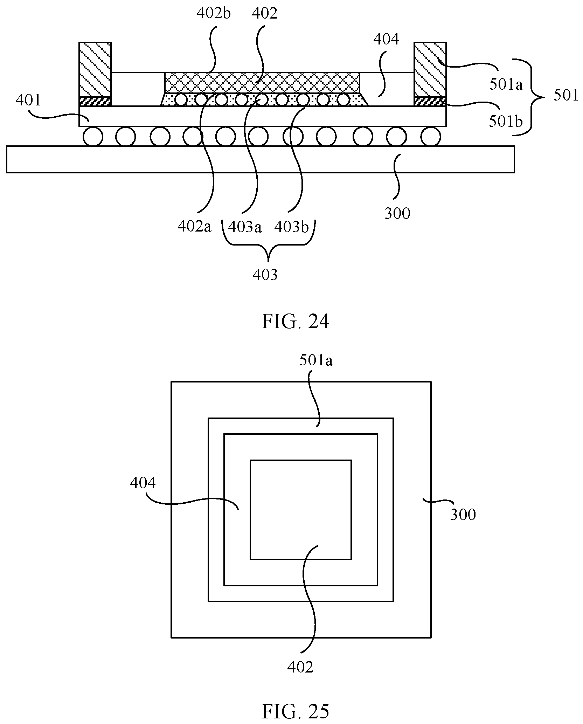

FIG. 24 is a schematic diagram 2 of a structure formed by performing S2001 in FIG. 20 according to example 2; and
FIG. 25 is a top view of the structure shown in FIG. 24.

numerals: 101a-Liquid inlet; 101b-Sprinkler-shaped flow channel; 101c-Liquid return port; 101-Refrigerating apparatus; 102-Spring screw; 103-Printed circuit board; 104-Supporting part; 105-Sealing kit; 106-Chip; 107-Accommodation cavity; 108-Substrate; 300-Printed circuit board; 301-Second pin; 400-Chip package structure; 401-Substrate; 402a-First surface; 402b-Second surface; 402-Chip; 403a-First pin; 403b-Underfill adhesive; 403-First pin layer; 404-Molding part; 405-Waterproof layer; 501a-Supporting part; 501b-Bonding adhesive; 501-Enclosure dam; 601a-Liquid inlet; 601b-Liquid return port; 601c-Sprinkler-shaped flow channel; 601-Refrigerating apparatus; 602-Spring screw; 603-Sealing kit; 604-Accommodation cavity; 701a-First bracket; 701b-Second bracket; 701-Bracket.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Terms "first", "second", and the like in this specification are merely intended for a purpose of description, and shall not be understood as an indication or implication of relative importance or implicit indication of a quantity of indicated technical features. Therefore, a feature limited by "first" or "second" may explicitly or implicitly include one or more such features. In the descriptions of this application, unless otherwise stated, "a plurality of" means two or more than two.

In addition, in this specification, orientation terms such as "top" and "bottom" are defined relative to orientations of structures in the accompanying drawings. It should be understood that these position terms are relative concepts used for relative description and clarification, and may correspondingly change based on changes in the orientations of the structures.

In this application, it should be noted that a term "connection" should be understood in a broad sense unless otherwise expressly specified and limited. For example, the "connection" may be a fixed connection, or may be a detachable connection or an integrated connection; and may be a direct connection, or may be an indirect connection through an intermediate medium. In addition, a term "coupling" may be a manner of implementing an electrical connection for signal transmission. The "coupling" may be a direct electrical connection, or may be an indirect electrical connection through an intermediate medium.

An embodiment of this application provides an electronic device. The electronic device includes an electronic device such as a server or a super computer. It may be understood that the electronic device may further include an electronic device used for industrial control, an electronic device of a data center, or the like. A specific form of the foregoing electronic device is not specifically limited in this embodiment of this application.

The electronic device may include a printed circuit board (printed circuit board, PCB) 300 shown in FIG. 4 and a chip package structure 400 disposed on the printed circuit board 300. The chip package structure 400 is connected to the printed circuit board 300 by using a plurality of pins.

The following describes in detail the chip package structure 400 and a chip packaging method with reference to FIG. 5 to FIG. 24.

As shown in FIG. 5 to FIG. 7, in some embodiments of this application, the chip package structure 400 includes a substrate 401, a chip (Die) 402, a first pin layer 403, a molding part 404, and a waterproof layer 405. A placement orientation of the structure shown in FIG. 5 is used as an example. The first pin layer 403 is disposed on the substrate 401, and the chip 402 is disposed on the first pin layer 403. The following describes a location relationship between components in the chip package structure 400 with reference to this orientation.

As shown in FIG. 5 to FIG. 7, the chip 402 has a first surface 402a close to the substrate 401 and a second surface 402b opposite to the first surface 402a.

In this embodiment of this application, a lower surface of the chip 402 is close to the substrate 401. In other words, the lower surface of the chip 402 is the first surface 402a. An upper surface of the chip 402 is away from the substrate 401. In other words, the upper surface of the chip 402 is the second surface 402b. It may be understood that an area of the first surface 402a or the second surface 402b may be larger than an area of any side surface of the chip 402.

As shown in FIG. 5 to FIG. 7, the first pin layer 403 includes a plurality of first pins 403a disposed between the first surface 402a of the chip 402 and the substrate 401. In other words, the first pin layer 403 is disposed between the lower surface of the chip 402 and the substrate 401, and the first pin layer 403 may include the plurality of first pins 403a.

In this embodiment of this application, the plurality of first pins 403a in the foregoing first pin layer 403 may be solder bumps (solder bumps), solder balls (solder balls), or copper pillars (Cu pillars). The plurality of first pins 403a in the first pin layer 403 are arranged in an array. For example, when the first pin 403a is a solder ball, the plurality of first pins 403a form a solder ball grid array (ball grid array, BGA). The chip 402 and the substrate 401 may be electrically connected by using the plurality of first pins 403a.

In addition, the first pin layer 403 may further include an underfill (Underfill) adhesive 403b. The underfill adhesive 403b is located in a gap between the first surface 402a and the substrate 401, to be specific, between the lower surface of the chip 402 and the substrate 401, and the underfill adhesive 403b may cover the plurality of first pins 403a. For an implementation of the underfill adhesive 403b, refer to a specific implementation of the underfill adhesive 403b in a conventional technology. Details are not described herein.

As shown in FIG. 5 to FIG. 7, the molding (Molding) package 404 is disposed on a periphery of the chip 402 and the first pin layer 403. In other words, the molding part 404 is disposed around the chip 402 and the first pin layer 403. In addition, a surface that is of the molding part 404 and that is away from the substrate 401 is higher than the first surface 402a of the chip 402. To be specific, an upper surface of the molding part 404 is higher than the lower surface of the chip 402. In other words, a distance between the surface that is of the molding part 404 and that is away from the substrate 401 and the substrate 401 is greater than a distance between the first surface 402a of the chip 402 and the substrate 401. To be specific, a distance between the upper surface of the molding part 404 and the substrate 401 is greater than a distance between the lower surface of the chip 402 and the substrate 401.

In addition, the molding part 404 covers a side surface of the first pin layer 403 and at least a part of a side surface of the chip 402. For example, the molding part 404 shown in FIG. 5 and FIG. 6 covers all side surfaces of the first pin layer 403 and all side surfaces of the chip 402. However, the molding part 404 shown in FIG. 7 covers all the side surfaces of the first pin layer 403 and a part of a side surface of the chip 402, for example, a part of a side surface close to a side of the substrate 401. Among surfaces of the molding part 404, two surfaces other than a surface in contact with the substrate 401 and a surface opposite to the substrate 401 are side surfaces. In other words, two surfaces between the upper surface of the molding part 404 and the lower surface of the molding part 404 are two side surfaces of the molding part 404. In the two side surfaces of the molding part 404, a side surface with a smaller distance from the side surface of the chip 402 is an inner side surface of the molding part 404, and a side surface with a larger distance from the side surface of the chip 402 is an outer side surface of the molding part 404.

It may be understood that the inner side surface of the molding part 404 is attached to a side surface that is of the chip 402 and that is covered by the molding part 404, and the inner side surface of the molding part 404 may be further attached to the side surface of the first pin layer 403. A surface that is of the molding part 404 and that is close to the substrate 401 may be attached to a surface that is of the substrate 401 and that is close to the chip 402. In other words, the lower surface of the molding part 404 may be attached to an upper surface of the substrate 401.

In this embodiment of this application, in this way, a refrigerating medium can be prevented from penetrating into the chip 402 from the side surface of the first pin layer 403 and the side surface of the chip 402. A material of the molding part 404 may be made of one or both of the following thermosetting materials: epoxy plastic or phenolic plastic. The epoxy plastic may include an epoxy resin, a hardening agent, a filling agent, or an additive agent.

It may be understood that the upper surface of the molding part 404 may be flush with the upper surface of the chip 402 in height, may be higher than the upper surface of the chip 402, or may be lower than the upper surface of the chip 402. The following uses examples for description with reference to FIG. 5 to FIG. 7.

In some embodiments, as shown in FIG. 5, the surface that is of the molding part 404 and that is away from the substrate 401 may be flush with the second surface 402b of the chip 402. To be specific, the upper surface of the molding part 404 is flush with the upper surface of the chip 402. In other words, the distance between the surface that is of the molding part 404 and that is away from the substrate 401 and the substrate 401 may be equal to a distance between the second surface 402b of the chip 402 and the substrate 401. The distance between the upper surface of the molding part 404 and the substrate 401 may be equal to a distance between the upper surface of the chip 402 and the substrate 401. In this case, the molding part 404 may cover all the side surfaces of the chip 402. The distance between the surface that is of the molding part 404 and that is away from the substrate 401 and the substrate 401 is the thickness or the height of the molding part 404 on the substrate 401. The distance between the second surface 402b of the chip 402 and the substrate 401 is the thickness or the height of the chip 402 on the substrate 401.

In this way, the molding part 404 covers all the side surfaces of the chip 402, so that refrigerating media that penetrate into the chip 402 from the side surface of the chip 402 may be further reduced, and waterproof performance may be further improved. In addition, when an edge of the chip 402 is squeezed by an external force, the molding part 404 may implement a buffering function, to better protect the chip 402 and further improve reliability. In addition, the surface that is of the molding part 404 and that is away from the substrate 401 is flush with the second surface 402b of the chip 402, so that the waterproof layer 405 can be easily processed, to improve efficiency.

For example, in the structure shown in FIG. 5, if the distance between the second surface 402b of the chip 402 and the substrate 401 is A, the distance between the surface that is of the molding part 404 and that is away from the substrate 401 and the substrate 401 is also A.

It may be understood that, in this embodiment of this application, the surface that is of the molding part 404 and that is away from the substrate 401 is flush with the second surface 402b of the chip 402 by using the substrate 401 as a reference for description. Unless otherwise specified, "higher than", "lower than", or "flush with" is described below by using the substrate 401 as a reference.

In some other embodiments, as shown in FIG. 6, the surface that is of the molding part 404 and that is away from the substrate 401 may be higher than the second surface 402b of the chip 402. To be specific, the upper surface of the molding part 404 is higher than the upper surface of the chip 402. In other words, the distance between the surface that is of the molding part 404 and that is away from the substrate 401 and the substrate 401 may be greater than the distance between the second surface 402b of the chip 402 and the substrate 401. To be specific, the distance between the upper surface of the molding part 404 and the substrate 401 may be greater than the distance between the upper surface of the chip 402 and the substrate 401. In this case, the molding part 404 covers all the side surfaces of the chip 402. In this way, refrigerating media that penetrate into the chip 402 from the side surface of the chip 402 may be further reduced, and waterproof performance may be further improved. In addition, when the edge of the chip 402 is squeezed by an external force, the molding part 404 may further implement a buffering function, to better protect the chip 402 and further improve reliability.

For example, if the distance between the second surface 402b of the chip 402 and the substrate 401 is A, and the distance between the surface that is of the molding part 404 and that is away from the substrate 401 and the substrate 401 is B, B is greater than A.

In still some other embodiments, as shown in FIG. 7, the surface that is of the molding part 404 and that is away from the substrate 401 may be lower than the second surface 402b of the chip 402. To be specific, the upper surface of the molding part 404 is lower than the upper surface of the chip 402. In other words, the distance between the surface that is of the molding part 404 and that is away from the substrate 401 and the substrate 401 may be less than the distance between the second surface 402b of the chip 402 and the substrate 401. To be specific, the distance between the upper surface of the molding part 404 and the substrate 401 may be less than the distance between the upper surface of the chip 402 and the substrate 401.

In this case, the molding part 404 covers a part of the side surface of the chip 402. In this way, process flows may be reduced. For example, in a process of forming the molding part 404, raw materials of the molding part 404 flowing to the second surface 402b of the chip 402 may be reduced, and the surface of the chip 401 is not covered by the molding part 404, to reduce grinding process flows of the upper surface of the chip 402, and improve efficiency. In addition, an upper part of the side surface of the chip 402 is not covered by the molding part 404, so that a heat dissipation area can be increased to improve heat dissipation efficiency.

For example, if the distance between the second surface 402b of the chip 402 and the substrate 401 is A, and the distance between the surface that is of the molding part 404 and that is away from the substrate 401 and the substrate 401 is C, C is less than A.

In this embodiment of this application, the waterproof layer 405 may be disposed in the chip package structure 400 shown in any one of FIG. 5 to FIG. 7.

As shown in FIG. 5 to FIG. 7, the waterproof layer 405 is disposed on the second surface 402b of the chip 402 and the surface that is of the molding part 404 and that is away from the substrate 401. In other words, the waterproof layer 405 is disposed on the upper surface of the chip 402 and the upper surface of the molding part 404. The waterproof layer 405 may be used to block the refrigerating medium, to prevent the cooling medium from penetrating into the chip 402 from the second surface 402b of the chip 402, and prevent the cooling medium from penetrating into the chip 402 from the side surface of the chip 402 or from the molding part 404.

Optionally, as shown in FIG. 5, when the upper surface of the molding part 404 is flush with the upper surface of the chip 402, the waterproof layer 405 may be disposed on one surface. In this way, the waterproof layer 405 can be conveniently disposed.

Alternatively, optionally, as shown in FIG. 6 or FIG. 7, when the upper surface of the molding part 404 is higher or lower than the upper surface of the chip 402, the waterproof layer 405 may be disposed on a plurality of surfaces. For example, the waterproof layer 405 is disposed on a side surface that is of the chip 402 and that is not covered by the molding part 404, for example, an upper part of the side surface of the chip 402 in FIG. 7. In other words, the waterproof layer 405 may be disposed on all of a part that is of the side surface of the chip 402 and that is not covered by the molding part 404, the second surface 402b of the chip 402, and the surface that is of the molding part 404 and that is away from the substrate 401. Alternatively, for example, the waterproof layer 405 is disposed on a part that is of the inner side surface of the molding part 404 and that is not in contact with the side surface of the chip 402, for example, an upper part of the inner side surface of the molding part 404 in FIG. 6. In other words, the waterproof layer 405 may be disposed on all of the part that is of the inner side surface of the molding part 404 and that is not covered by the molding part 404, the second surface 402b of the chip 402, and the surface that is of the molding part 404 and that is away from the substrate 401.

As shown in FIG. 8, for example, the waterproof layer 405 may include one or more of the following: a first waterproof sublayer, a second waterproof sublayer, or a third waterproof sublayer.

The first waterproof sublayer may include a thin film made from one of the following: titanium (Ti), nickel (Ni), or carbon. For example, the first waterproof sublayer is made from carbon, and the first waterproof sublayer may be a diamond-like carbon (diamond-like carbon, DLC) film. The diamond-like carbon film may be formed through a sputtering process. It may be understood that a thin film made from titanium (Ti), a thin film made from nickel (Ni), or a thin film made from carbon all has a characteristic of low water vapor transmittance. Therefore, a waterproof function can be implemented. In addition, the first waterproof sublayer can further prevent the refrigerating medium from impacting a surface of the chip.

The second waterproof sublayer may include a thin film made from one of the following: silicon dioxide (SiO₂) or aluminum oxide, for example, aluminium trioxide. The aluminum oxide is used as an example. The second waterproof sublayer may be an aluminum oxide film. The aluminum oxide film may be formed through an atomic layer deposition process. A thin film made from silicon dioxide or a thin film made from aluminum oxide has the characteristic of low water vapor transmittance, so that the waterproof function can be implemented.

The third waterproof sublayer may include an organic layer, and the organic layer may be made from parylene (parylene). The organic layer has the characteristic of low water vapor transmittance, so that the waterproof function can be implemented.

Optionally, the waterproof layer 405 may include only two layers. For example, the waterproof layer 405 may include the first waterproof sublayer and the second waterproof sublayer. The first waterproof sublayer and the second waterproof sublayer are sequentially disposed on the second surface 402b. In this way, the waterproof performance can be further improved. Alternatively, the waterproof layer 405 may include only one layer. For example, the waterproof layer 405 may include only the first waterproof sublayer.

It should be noted that the first waterproof sublayer, the second waterproof sublayer, or the third waterproof sublayer may alternatively be implemented by using another material. The materials of the layers listed above are merely used as examples, and do not limit a specific implementation of the first waterproof sublayer, the second waterproof sublayer, or the third waterproof sublayer.

To further improve waterproof effect, the waterproof layer 405 may alternatively be disposed on a surface that is of a supporting part 501a and that is away from the substrate 401. To be specific, the waterproof layer 405 is disposed on an upper surface of the supporting part 501a.

In the chip package structure shown in FIG. 5 to FIG. 7, the molding part 404 is disposed on the periphery of the chip 402 and the first pin layer 403, and the waterproof layer 405 is disposed on the surface that is of the molding part 404 and that is away from the substrate 401 and the second surface 402b of the chip 402. A combination of the molding part 404 and the waterproof layer 405 may prevent the refrigerating medium from penetrating into the chip 402 and the first pin layer 403, to improve the waterproof performance of the chip 402. This improves reliability of the chip 402.

In addition, the molding part 404 is disposed on the substrate 401. Because the molding part 404 has a large modulus and cannot be easily deformed, deformation of the substrate 401 may be limited when the substrate 401 warps, to reduce a warping degree of the substrate 401. This reduces circuit faults caused by deterioration in the waterproof performance and poor contact. For example, in a possible implementation, a modulus of the substrate 401 is 27 giga pascals (giga pascals, GPa), and the modulus of the molding part 404 may be 12.7 GPa or 0.6 GPa. It may be understood that, in this embodiment of this application, that the molding part 404 has a large modulus means that when the molding part 404 is subject to a same stress, a deformation magnitude of the molding part 404 is less than a deformation magnitude of gas or liquid.

To better reduce the warping degree of the substrate 401, an expansion coefficient of the molding part 404 may be less than an expansion coefficient of the substrate 401. For example, the expansion coefficient of the substrate 401 is 20*10⁻6 per Celsius temperature (per Celsius temperature, /°C), and the expansion coefficient of the molding part 404 may be 18*10⁻6/°C. In this way, when a temperature changes, the substrate 401 and the chip 402 may be better fastened together, to implement expansion coefficient matching between the substrate 401 and the chip 402, reduce a difference between deformation of the substrate 401 and the chip 402, and reduce the warping degree of the substrate 401. This reduces the circuit faults caused by the deterioration in the waterproof performance and the poor contact. The expansion coefficient of the substrate 401 or the molding part 404 may be implemented by selecting a material of the substrate 401 or the molding part 404. For an implementation of the material of the substrate 401 or the molding part 404, correspondingly refer to an implementation of a material of the substrate 401 or the molding part 404 in a conventional technology. Details are not described herein.

The chip package structure 400 shown in FIG. 5 is used as an example. As shown in FIG. 9 to FIG. 11, the chip package structure 400 may further include the supporting part (Ring) 501a. The supporting part 501a is disposed on the substrate 401, and the supporting part 501a surrounds the molding part 404. In other words, the supporting part 501a is disposed around the molding part 404. In this way, a refrigerating apparatus 601 and the supporting part 501a shown in FIG. 13 may apply an external force to an edge of the substrate 401, to further reduce the warping degree of the substrate 401. This reduces the circuit faults caused by the deterioration in the waterproof performance and the poor contact. On this basis, to prevent the refrigerating medium from penetrating into the chip 402 from the outer side surface of the molding part 404, and further improve the waterproof effect, the outer side surface of the molding part 404 is attached to an inner side surface of the supporting part 501a.

It may be understood that, among surfaces of the supporting part 501a, two surfaces other than two surfaces opposite to the substrate 401 are side surfaces. In the two side surfaces of the supporting part 501a, a side surface having a smaller distance from the side surface of the chip 402 is the inner side surface of the supporting part 501a.

In this case, the outer side surface of the molding part 404 is attached to the inner side surface of the supporting part 501a, to avoid a case in which the refrigerating medium penetrates into a bonding adhesive 501b from a position between the molding part 404 and the supporting part 501a to cause failure of the bonding adhesive 501b and cause leakage of the refrigerating medium. This further improves the reliability of the chip 402.

For example, the supporting part 501a may be bonded to the substrate 401 by using the bonding adhesive 501b. In this case, the supporting part 501a and the bonding adhesive 501b may form an enclosure dam 501. The enclosure dam 501 may be used to limit a thermosetting material for forming the molding part 404 in the process of forming the molding part 404. The outer side surface of the molding part 404 may alternatively be attached to an inner side surface of the bonding adhesive 501b. The inner side surface of the bonding adhesive 501b is a side surface that is of the bonding adhesive 501b and that is close to the substrate 401, and an outer side surface of the bonding adhesive 501b is a side surface that is of the bonding adhesive 501b and that is close to the substrate 401.

It should be noted that the supporting part 501a may be made of a metal material, for example, copper alloy or stainless steel. The bonding adhesive 501b may also be referred to as an AD bonding adhesive. The bonding adhesive 501b in this embodiment of this application may be implemented by using an existing material having a bonding function. Details are not described herein.

Refer to FIG. 9 to FIG. 11. The surface that is of the supporting part 501a and that is away from the substrate 401 is higher than the surface that is of the chip 402 and that is away from the substrate 401, may be lower than the surface that is of the chip 402 and that is away from the substrate 401, or may be flush with the surface that is of the chip 402 and that is away from the substrate. In other words, the upper surface of the supporting part 501a is behigher than the upper surface of the chip 402, may be lower than the upper surface of the chip 402, or may be flush with the upper surface of the chip 402 in height. The following uses examples for description with reference to FIG. 9 to FIG. 11.

In some embodiments not encompassed by the subj ect-matter of the claims but considered useful for understanding the invention, as shown in FIG. 9, the surface that is of the supporting part 501a and that is away from the substrate 401 may be flush with the second surface 402b of the chip 402. To be specific, the upper surface of the supporting part 501a is flush with the upper surface of the chip 402. In other words, a distance between the surface that is of the supporting part 501a and that is away from the substrate 401 and the substrate 401 may be equal to the distance between the second surface 402b of the chip 402 and the substrate 401. To be specific, a distance between the upper surface of the supporting part 501a and the substrate 401 may be equal to the distance between the upper surface of the chip 402 and the substrate 401. In this case, the supporting part 501a may form the enclosure dam 501, to form the molding part 404.

For example, if the distance between the second surface 402b of the chip 402 and the substrate 401 is A, the distance between the surface that is of the supporting part 501a and that is away from the substrate 401 and the substrate 401 is also A.

As shown in FIG. 10, the surface that is of the supporting part 501a and that is away from the substrate 401 is higher than the second surface 402b of the chip 402. To be specific, the upper surface of the supporting part 501a is higher than the upper surface of the chip 402. In other words, a distance between the surface that is of the supporting part 501a and that is away from the substrate 401 and the substrate 401 may be greater than the distance between the second surface 402b of the chip 402 and the substrate 401. To be specific, the distance between the upper surface of the supporting part 501a and the substrate 401 may be greater than the distance between the upper surface of the chip 402 and the substrate 401. The distance between the surface that is of the supporting part 501a and that is away from the substrate 401 and the substrate 401 is the height of the surface that is of the supporting part 501a and that is away from the substrate 401 relative to the upper surface of the substrate 401. In this way, pressure can be better applied to the substrate 401 by using the supporting part 501a, to further reduce the warping degree of the substrate 401. This further improves the waterproof performance of the chip 402 and alleviates a problem of poor contact between electronic components caused by warping of the substrate 401. In addition, the supporting part 501a may form the enclosure dam 501, to form the molding part 404.

For example, if the distance between the second surface 402b of the chip 402 and the substrate 401 is A, and a first distance between the surface that is of the supporting part 501a and that is away from the substrate 401 and the substrate 401 is D, A is less than D.

In still some other embodiments not encompassed by the subject-matter of the claims but considered useful for understanding the invention, as shown in FIG. 11, the surface that is of the supporting part 501a and that is away from the substrate 401 may be lower than the second surface 402b of the chip 402. To be specific, the upper surface of the supporting part 501a may be lower than the upper surface of the chip 402. In other words, a distance between the surface that is of the supporting part 501a and that is away from the substrate 401 and the substrate 401 may be less than the distance between the second surface 402b of the chip 402 and the substrate 401. To be specific, the distance between the upper surface of the supporting part 501a and the substrate 401 may be less than the distance between the upper surface of the chip 402 and the substrate 401. In this way, operations, for example, grinding the molding part 404 or the chip 402, can be more conveniently performed, to improve efficiency.

For example, if the distance between the second surface 402b of the chip 402 and the substrate 401 is A, and the distance between the surface that is of the supporting part 501a and that is away from the substrate 401 and the substrate 401 is E, A is larger than E.

It should be noted that, as shown in FIG. 11, the molding part 404 may extend to the surface that is of the supporting part 501a and that is away from the substrate 401, and cover the surface that is of the supporting part 501a and that is away from the substrate 401.

It may be understood that, in the chip package structure 400 including the supporting part 501a, the surface that is of the supporting part 501a and that is away from the substrate 401 may be flush with the surface that is of the molding part 404 and that is away from the substrate 401. To be specific, the upper surface of the supporting part 501a may be flush with the upper surface of the chip 402. Alternatively, the surface that is of the supporting part 501a and that is away from the substrate 401 may be higher than the surface that is of the molding part 404 and that is away from the substrate 401. To be specific, the upper surface of the supporting part 501a may be higher than the upper surface of the chip 402. Alternatively, the surface that is of the supporting part 501a and that is away from the substrate 401 may be lower than the surface that is of the molding part 404 and that is away from the substrate 401. To be specific, the upper surface of the supporting part 501a may be lower than the upper surface of the chip 402.

It should be noted that, in this embodiment of this application, a height of the upper surface of the supporting part 501a (where the supporting part 501a exists and the upper surface of the supporting part 501a is not covered by the molding part 404) or the molding part 404 (where the supporting part 501a does not exist or the upper surface of the supporting part 501a is covered by the molding part 404) may match the refrigerating apparatus 601 shown in FIG. 12 not encompassed by the subject-matter of the claims but considered useful for understanding the invention or FIG. 13, so that an accommodation cavity 604 shown in FIG. 12 or FIG. 13 is large enough to accommodate sufficient refrigerants. In addition, the supporting part 501a or the molding part 404 may further fasten the chip 402, to avoid deformation of the substrate 401 and the chip 402.

Similarly, in the structure shown in FIG. 6 or FIG. 7, the supporting part 501a may also be disposed. For a specific implementation, refer to the specific implementation of the supporting part 501a shown in FIG. 9. Details are not described herein.

In some possible design solutions, as shown in either FIG. 12 or FIG. 13, any chip package structure 400 in FIG. 5 to FIG. 7 or FIG. 9 to FIG. 11 may further include the refrigerating apparatus 601. The refrigerating apparatus 601 has a liquid inlet 601a, a liquid return port 601b, and a sprinkler-shaped flow channel 601c. The accommodation cavity 604 for accommodating a refrigerant is formed between the sprinkler-shaped flow channel 601c, the liquid return port 601b, and the waterproof layer 405. The accommodation cavity 604 covers at least areas that are on the waterproof layer 405 and that correspond to the second surface 402b of the chip 402. The liquid inlet 601a is in communication with the sprinkler-shaped flow channel 601c, the sprinkler-shaped flow channel 601c is in communication with the accommodation cavity 604, and the accommodation cavity 604 is in communication with the liquid return port 601b.

For example, the chip package structure 400 may be connected to the printed circuit board 300 by using the substrate 401. The substrate 401 and the refrigerating apparatus 601 are located on a same side of the printed circuit board 300. It may be understood that a second pin layer may be disposed between the substrate 401 and the printed circuit board 300, and the second pin layer may include a plurality of second pins 301. The substrate 401 may be electrically connected to the printed circuit board 300 by using the plurality of second pins 301. For an implementation of the second pin layer, refer to an existing implementation. Details are not described herein.

The refrigerating apparatus 601 may be fastened on the printed circuit board 300 by using a connecting piece such as a spring screw 602 or a screw. To improve reliability of the refrigerating apparatus 601, brackets 701 may be further disposed on two sides of the printed circuit board 300, and the refrigerating apparatus 601 is connected to the bracket 701 by using the spring screw 602. The bracket 701 may include one or both of the following: a first bracket 701a or a second bracket 701b. The first bracket 701a is disposed on a side that is of the printed circuit board 300 and that is close to the substrate 401, and the second bracket 701b is disposed on a side that is of the printed circuit board 300 and that is away from the substrate 401.

It should be noted that, after the connecting piece is connected to the refrigerating apparatus 601, a distance between the refrigerating apparatus 601 and the waterproof layer 405 on the chip 402 is greater than a distance threshold, so that the accommodation cavity 604 can accommodate sufficient refrigerating media, to ensure a refrigerating effect.

Similarly, on the package structure shown in any one of FIG. 6, FIG. 7, and FIG. 9 to FIG. 11, the refrigerating apparatus 601 may also be disposed. For a specific implementation, refer to the specific implementation of the refrigerating apparatus 601 shown in FIG. 12 or FIG. 13. Details are not described herein.

It may be understood that the refrigerating apparatus 601 in this embodiment of this application may be a jet liquid-refrigerating apparatus.

To further understand the solutions in embodiments of this application, the following describes a refrigeration principle of the foregoing package structure by using an example with reference to FIG. 12 and FIG. 13.

For example, as shown in FIG. 12 or FIG. 13, when the chip 402 works, heat generated is conducted to the second surface 402b of the chip 402, and is further conducted to the waterproof layer 405. The liquid inlet 601a and the liquid return port 601b of the refrigerating apparatus 601 are connected to a liquid supply system (not shown in FIG. 13) of the refrigerating medium. Driven by the liquid supply system, the refrigerating medium is injected into the sprinkler-shaped flow channel 601c through the liquid inlet 601a of the refrigerating apparatus 601, and then enters the accommodation cavity 604 through the sprinkler-shaped flow channel 601c. The refrigerating medium that enters the accommodation cavity 604 performs heat exchange with the waterproof layer 405, to absorb the heat generated by the chip 402. After absorbing the heat, the refrigerating medium flows out of the accommodation cavity 604 through the liquid return port 601b of the refrigerating apparatus 601, to transfer the heat out of the chip package structure 400, and implement heat dissipation of the chip 402.

In this way, heat dissipation can be implemented on the second surface 402b of the chip 402, and the first pins 403a may be arranged in all the areas corresponding to the second surface 402b, without a limitation. All the areas corresponding to the second surface 402b may be areas at which the second surface 402b is projected in a direction perpendicular to the second surface 402b.

In this case, to prevent a refrigeration fluid from penetrating from the accommodation cavity 604 to structures such as the printed circuit board 300 other than the accommodation cavity 604, a sealing kit 603 may be further disposed between the refrigerating apparatus 601 and the waterproof layer 405.

In some embodiments, with reference to FIG. 5 to FIG. 7 and FIG. 9 to FIG. 11, as shown in FIG. 12, the sealing kit 603 may be disposed on the waterproof layer 405 covering the molding part 404. The sealing kit 603 is separately in contact with the waterproof layer 405 and the refrigerating apparatus 601. In this case, the sealing kit 603 surrounds the areas that are on the waterproof layer 405 and that correspond to the second surface 402b.

In some other embodiments, with reference to FIG. 9 to FIG. 11, as shown in FIG. 13, the sealing kit 603 may be disposed on the supporting part 501a. For example, as shown in FIG. 9, the sealing kit 603 is separately in contact with the waterproof layer 405 covering the upper surface of the supporting part 501a and the refrigerating apparatus 601. For another example, as shown in FIG. 10, the sealing kit 603 is disposed on the upper surface of the supporting part 501a. For still another example, as shown in FIG. 11, the sealing kit 603 is disposed on an area that is on the waterproof layer 405 and that corresponds to the upper surface of the supporting part 501a, and is separately in contact with the waterproof layer 405 and the refrigerating apparatus 601.

The area that is on the waterproof layer 405 and that corresponds to the second surface 402b may be an area at which the second surface 402b is projected on the waterproof layer 405 in the direction perpendicular to the second surface 402b.

It should be noted that pressure at the sealing kit 603 should be greater than a first pressure threshold and less than or equal to a second pressure threshold, to avoid a poor sealing effect caused by excessively low pressure, or avoid damage to the waterproof layer 405 or the supporting part 501a of the chip package structure 400 caused by excessively high pressure. The first pressure threshold is a minimum pressure bearing requirement of the sealing kit 603 during working. A value, a material, and a dimension of the first pressure threshold may be determined according to a use standard of a sealing kit 603 in a conventional technology, for example, a use standard of a sealing ring. Details are not described herein. The second pressure threshold is related to a related parameter of the chip 402 and the first pin 403a on the first surface 402a. For example, the first pin 403a is a solder ball, and the second pressure threshold may be related to a quantity of solder balls on the chip. For example, for solder balls of some pressure bearing specifications, the second pressure threshold may be 30 grams per ball (grams per ball, g/ball).

An embodiment of this application further provides a chip packaging method. The packaging method is applicable to the chip package structure 400 shown in any one of FIG. 5 to FIG. 7 or FIG. 9 to FIG. 13. The chip packaging method may be performed before the substrate 401 is connected to the printed circuit board 300, or may be performed after the substrate 401 is connected to the printed circuit board 300. In other words, the chip packaging method may be performed before board loading. In other words, packaging is performed in a production process of the chip 402. Alternatively, the chip packaging method may be performed after board loading. In other words, packaging is performed in a process of an intermediate product (for example, a PCB board) of a production device. The following describes the chip packaging method in this embodiment of this application with reference to specific examples.

Example 1: The following uses an example in which the chip packaging method is performed before the substrate 401 is connected to the printed circuit board 300 for description. Refer to FIG. 5. As shown in FIG. 14, the chip packaging method may include S1401 and S1402.

S1401: Form, on the substrate 401, the molding part 404 that surrounds a chip 402.

For example, the molding part 404 may be formed in the following manners: a molding process, an injection molding process, or a glue dispensing and curing process.

It may be understood that, in this embodiment of this application, before the operation S1401 is performed, a connection structure of the substrate 401, a first pin layer 403, and the chip 402 is shown in FIG. 15. The chip 402 is disposed on the substrate 401, and the first pin layer 403 is disposed between the chip 402 and the substrate 401. For a connection manner of the substrate 401, the first pin layer 403, and the chip 402, refer to a connection manner of the substrate 401, the first pin layer 403, and the chip 402 in a conventional technology.

The following describes in detail a manner of performing S1401 by using an example with reference to the glue dispensing and curing process.

Manner 1 not encompassed by the subject-matter of the claims but considered useful for understanding the invention: Glue dispensing and curing are directly performed to form the molding part 404.

As shown in FIG. 16 not encompassed by the subject-matter of the claims but considered useful for understanding the invention, the molding part 404 that surrounds a side surface of the chip 402 and a side surface of the first pin layer 403 is formed through the glue dispensing and curing process.

Optionally, in this embodiment of this application, an outer side surface or an upper surface of the molding part 404 may be irregular. In this case, after a material for forming the molding part 404 is cured, an operation such as grinding or polishing may be further performed on the outer side surface or the upper surface of the molding part 404.

Manner 2: The molding part 404 is formed between an enclosure dam 501 and the chip 402, as shown in (a) in FIG. 17 or (b) in FIG. 17.

For example, S1401 is performed on the structure shown in (a) in FIG. 17 or (b) in FIG. 17, to correspondingly form a structure shown in FIG. 16 or FIG. 18. In this case, in S1401, the forming, on the substrate 401, the molding part 404 that surrounds the chip 402 may include: forming, between the chip 402 and the enclosure dam 501 through the glue dispensing and curing process, the molding part 404 that surrounds the side surface of the chip 402 and the side surface of the first pin layer 403.

In this case, before the forming, on the substrate 401, the molding part 404 that surrounds the chip 402 in S1401, the chip packaging method shown in FIG. 14 may further include step 1.

Step 1: Form the enclosure dam 501 for limiting the molding part 404 on a periphery of the chip 402. The enclosure dam 501 is located on the substrate 401.

Optionally, in step 1, the forming the enclosure dam 501 for limiting the molding part 404 on a periphery of the chip 402 may include: as shown in (a) in FIG. 17, in the structure shown in FIG. 15, disposing a thermosetting material on the substrate 401 around the chip 402 through the dispensing process. Then, the thermosetting material around the chip 402 is heated to a preset temperature, so that the thermosetting material is attached to the side surface of the first pin layer 403, the side surface of the chip 402, and a part of the surface of the substrate 401 that is close to the chip 401 (that is, the upper surface of the substrate 401) and that is not covered by the first pin layer 403. Then, the thermosetting material is cooled so that the thermosetting material is cured, to form the enclosure dam 501. A material of the enclosure dam 501 may be the same as the material of the molding part 404.

It may be understood that, in this embodiment of this application, an outer side surface or an upper surface of the enclosure dam 501 may be irregular. In this case, after the material for forming the enclosure dam 501 is cured, an operation such as grinding or polishing may be further performed on the outer side surface or the upper surface of the enclosure dam 501.

Alternatively, optionally, in step 1, the forming the enclosure dam 501 for limiting the molding part 404 on a periphery of the chip 402 may include: as shown in (b) in FIG. 17, in the structure shown in FIG. 15, bonding the supporting part 501a to the substrate 401 on the periphery of the chip 402 by using the bonding adhesive 501b. In other words, a structure including the supporting part S01a and the bonding adhesive 501b may be used as the enclosure dam 501. The supporting part 501a and the chip 402 are located on a same side of the substrate 401.

In addition, for descriptions of structures and materials of the supporting part 501a and the molding part 404, refer to the foregoing structure descriptions and the foregoing material descriptions of the chip package structure 400. Details are not described herein again.

It should be noted that, in this embodiment of this application, grinding the surface that is of the molding part 404 and that is away from the substrate 401 and/or the second surface 402b of the chip 402 through the grinding process makes the surface that is of the molding part 404 and that is away from the substrate 401 be flush with the second surface 402b of the chip 402. To be specific, grinding the upper surface of the molding part 404 or the upper surface of the chip 402 makes the upper surface of the molding part 404 be flush with the upper surface of the chip 402.

It may be understood that, as shown in FIG. 14, before the forming, on the substrate 401, the molding part 404 that surrounds the chip 402 in S1401, the chip packaging method shown in FIG. 14 may further include step 2.

Step 2: Connect the chip 402 to the substrate 401 to form the structure shown in FIG. 15.

In addition, for descriptions of a specific structure and material of the molding part 404 or the supporting part 501a formed by performing S1401, refer to the foregoing structure descriptions and the foregoing material descriptions of the chip package structure 400. Details are not described herein again.

S1402: Form the waterproof layer 405 on the second surface 402b of the chip 402 and the surface that is of the molding part 404 and that is away from the substrate 401.

It may be understood that the first waterproof sublayer, the second waterproof sublayer, or the third waterproof sublayer may be formed through one of the following processes: physical vapor deposition (physical vapor deposition, PVD), chemical vapor deposition (chemical vapor deposition, CVD), and atomic layer deposition (atomic layer deposition, ALD). For example, the waterproof layer 405 includes the first waterproof sublayer, the second waterproof sublayer, or the third waterproof sublayer shown in FIG. 11. The first waterproof sublayer is first formed, and then the second waterproof sublayer is formed on a side that is away from the chip 402 or the molding part 404. Next, the third waterproof sublayer is formed on a side that is of the second waterproof layer and that is away from the chip 402 or the molding part 404.

For structure descriptions and material descriptions of the waterproof layer 405, refer to the foregoing structure descriptions of the chip package structure 400. Details are not described herein again. It may be understood that the foregoing process for forming the waterproof layer 405 is merely used as an example. In an actual implementation, another process may be used based on an actual scenario.

A structure obtained after the waterproof layer 405 is formed in the structure shown in FIG. 16 is shown in FIG. 5. A structure obtained after the waterproof layer 405 is formed in the structure shown in FIG. 18 is shown in FIG. 10.

Optionally, the chip packaging method shown in FIG. 14 in this embodiment of this application may further include S1403.

S1403: Connect the substrate 401 in the chip package structure 400 to the printed circuit board 300. After the chip package structure 400 shown in FIG. 5 performs S1403, a structure shown in (a) in FIG. 19 not encompassed by the subject-matter of the claims but considered useful for understanding the invention is formed. After the chip package structure 400 shown in FIG. 10 performs S1403, a structure shown in (b) in FIG. 19 is formed.

As shown in FIG. 12 or FIG. 13, in this embodiment of this application, a structure formed after S1403 is performed may be further connected to the refrigerating apparatus 601. For example, the structure shown in (a) in FIG. 19 is connected to the refrigerating apparatus 601 to form the structure shown in FIG. 12. For another example, the structure shown in (b) in FIG. 19 is connected to the refrigerating apparatus 601, to form the structure shown in FIG. 13.

Example 2: The following uses an example in which the chip packaging method is performed after the substrate 401 is connected to the printed circuit board 300 for description. Refer to FIG. 5. As shown in FIG. 20, the chip packaging method may include S2001 and S2002.

S2001: Form, on a substrate 401, a molding part 404 that surrounds a chip 402.

For example, the molding part 404 may be formed in the following manners: a molding process, an injection molding process, or a glue dispensing and curing process.

It may be understood that, when S2001 starts to be performed, initial states of the substrate 401, a first pin layer 403, the chip 402, and a printed circuit board 300 are shown in FIG. 21 not encompassed by the subject-matter of the claims but considered useful for understanding the invention. The substrate 401 is disposed on the printed circuit board 300, and the chip 402 is disposed on a side that is of the substrate 401 and that is away from the printed circuit board 300. The first pin layer 403 is disposed between the chip 402 and the substrate 401.

The following describes in detail a manner of performing S2001 by using an example with reference to the glue dispensing and curing process.

Manner 3 not encompassed by the subject-matter of the claims but considered useful for understanding the invention: Glue dispensing and curing are directly performed to form the molding part 404.

For an implementation of Manner 3, refer to the specific implementation of Manner 1. Details are not described herein again.

In this way, the structure shown in FIG. 21 may form a structure shown in FIG. 22 not encompassed by the subject-matter of the claims but considered useful for understanding the invention.

Manner 4: The molding part 404 is formed between the enclosure dam 501 and the chip 402, as shown in (a) in FIG. 23 or (b) in FIG. 23.

For an implementation of Manner 4, refer to the specific implementation of Manner 3. Details are not described herein again.

In this case, before S2001 is performed, the chip packaging method shown in FIG. 20 may further include step 4.

Step 4: Form the enclosure dam 501 for limiting the molding part 404 on the periphery of the chip 402. For a specific implementation of step 4, refer to the implementation of step 1. Details are not described herein again.

After step 4 is performed, the structure shown in FIG. 21 may form a structure shown in (a) in FIG. 23 or (b) in FIG. 23.

Optionally, in this embodiment of this application, before step 4 is performed, the chip packaging method shown in FIG. 20 may further include: Step 5: Connect the chip 402 to the substrate 401 to form the structure shown in FIG. 15.

Optionally, before the forming, on the substrate 401, the molding part 404 that surrounds the chip 402 in S2001, the chip packaging method shown in FIG. 20 may further include S2000. S2000: Connect the substrate 401 to the printed circuit board 300 to form the structure shown in FIG. 21. S2000 may be performed before step 4, or may be performed after step 4. This is not limited in this embodiment of this application.

S2002: Form the waterproof layer 405 on the second surface 402b of the chip 402 and the surface that is of the molding part 404 and that is away from the substrate 401.

For example, with reference to the structure shown in FIG. 22, the operation S2002 is performed, to form the structure shown in (a) in FIG. 19. The operation S2002 is performed on a structure shown in FIG. 24, to form the structure shown in (b) in FIG. 19.

It may be understood that, in this embodiment of this application, a top view of the structure shown in FIG. 24 is shown in FIG. 25.

For an implementation of S2002, refer to the specific implementation of S1402. Details are not described herein again.

In addition, for descriptions of the structure and the material of the molding part 404, refer to the foregoing structure descriptions and the foregoing material descriptions of the chip package structure 400. Details are not described herein again.

The foregoing chip packaging method achieves a same technical effect as the chip package structure 400 provided in the foregoing embodiments. Details are not described herein again.

## Claims

1. A chip package structure (400), comprising:
a substrate (401);
a chip (402), having a first surface (402a) close to the substrate (401) and a second surface (402b) opposite to the first surface (402a);
a first pin layer (403), comprising a plurality of pins disposed between the first surface (402a) of the chip (402) and the substrate (401);
a molding part (404), disposed on a periphery of the chip (402) and the first pin layer (403), wherein a surface that is of the molding part (404) and that is away from the substrate (401) is higher than the first surface (402a) of the chip (402), and covers a side surface of the first pin layer (403) and at least a part of a side surface of the chip (402), and the molding part (404) is attached to the side surface of the chip (402); and
a waterproof layer (405), disposed on the second surface (402b) of the chip (402) and the surface that is of the molding part (404) and that is away from the substrate (401);
wherein the chip package structure (400) further comprises:
a supporting part (501a), disposed on the substrate (401), wherein the supporting part (501a) surrounds the molding part (404), and an outer side surface of the molding part (404) is attached to an inner side surface of the supporting part (501a), wherein a surface that is of the supporting part (501a) and that is away from the substrate (401) is higher than the second surface (402b) of the chip (402).

2. The chip package structure (400) according to claim 1, wherein the molding part (404) covers all side surfaces of the chip (402), and the surface that is of the molding part (404) and that is away from the substrate (401) is flush with the second surface (402b) of the chip (402).

3. The chip package structure (400) according to claim 1, wherein the surface that is of the molding part (404) and that is away from the substrate (401) is lower than the second surface (402b) of the chip (402).

4. The chip package structure (400) according to any one of claims 1 to 3, further comprising:
a refrigerating apparatus (101, 601), comprising a liquid inlet (101a, 601a), a liquid return port (101c, 601b), and a sprinkler-shaped flow channel (101b, 601c), wherein an accommodation cavity (107, 604) for accommodating a refrigerant is formed between the sprinkler-shaped flow channel (101b, 601c), the liquid return port (101c, 601b), and the waterproof layer (405), the accommodation cavity (107, 604) covers at least the waterproof layer (405) corresponding to the second surface (402b) of the chip (402), the liquid inlet (101a, 601a) is in communication with the sprinkler-shaped flow channel (101b, 601c), the sprinkler-shaped flow channel (101b, 601c) is in communication with the accommodation cavity (107, 604), and the accommodation cavity (107, 604) is in communication with the liquid return port (101c, 601b).

5. An electronic device, wherein the electronic device comprises a printed circuit board (103, 300) and at least one chip package structure (400) according to any one of claims 1 to 4, and the chip package structure (400) is connected to the printed circuit board (103, 300).

6. A chip packaging method, wherein the method comprises:
forming, on a periphery of a chip (402), an enclosure dam (501) for limiting a molding part (404), wherein the enclosure dam (501) is located on a substrate (401);
forming, on the substrate (401), the molding part (404) that surrounds the chip (402), wherein the forming, on the substrate (401), the molding part (404) that surrounds the chip (402) comprises: forming the molding part (404) between the enclosure dam (501) and the chip (402), and wherein the enclosure dam (501) is a supporting part (501a), and an outer side surface of the molding part (404) is attached to an inner side surface of the supporting part (501a), and wherein the chip (402) is disposed on the substrate (401), the chip (402) has a first surface (402a) close to the substrate (401) and a second surface (402b) opposite to the first surface (402a), the first surface (402a) is connected to the substrate (401) through a first pin layer (403), the first pin layer (403) comprises a plurality of pins disposed between the first surface (402a) of the chip (402) and the substrate (401), a surface that is of the molding part (404) and that is away from the substrate (401) is higher than the first surface (402a) of the chip (402), the molding part (404) covers a side surface of the first pin layer (403) and at least a part of a side surface of the chip (402), and the molding part (404) is attached to the side surface of the chip (402), and wherein a surface that is of the supporting part (501a) and that is away from the substrate (401) is higher than the second surface (402b) of the chip (402); and
forming a waterproof layer (405) on the second surface (402b) of the chip (402) and the surface that is of the molding part (404) and that is away from the substrate (401).

7. The chip packaging method according to claim 6, wherein the molding part (404) covers all side surfaces of the chip (402), and the surface that is of the molding part (404) and that is away from the substrate (401) is flush with the second surface (402b) of the chip (402).

8. The chip packaging method according to claim 6, wherein the surface that is of the molding part (404) and that is away from the substrate (401) is lower than the second surface (402b) of the chip (402).

9. The chip packaging method according to any one of claims 6 to 8, wherein before the forming, on a substrate (401), a molding part (404) that surrounds a chip (402), the method further comprises:
connecting the substrate (401) to a printed circuit board (103, 300).

10. The chip packaging method according to any one of claims 6 to 8, wherein after the forming a waterproof layer (405) on the second surface (402b) of the chip (402) and the surface that is of the molding part (404) and that is away from the substrate (401), the method further comprises:
connecting the substrate (401) to a printed circuit board (103, 300).

## Patentansprüche

1. Chipgehäusestruktur (400), umfassend:
ein Substrat (401);
einen Chip (402), der eine erste Fläche (402a) nahe dem Substrat (401) und eine zweite Fläche (402b) gegenüber der ersten Fläche (402a) aufweist;
eine erste Stiftschicht (403), die eine Vielzahl von Stiften umfasst, die zwischen der ersten Fläche (402a) des Chips (402) und dem Substrat (401) angeordnet ist;
ein Formteil (404), das an einem Umfang des Chips (402) und der ersten Stiftschicht (403) angeordnet ist, wobei eine Fläche das Formteils (404), die vom Substrat (401) weg weist, höher ist als die erste Fläche (402a) des Chips (402) und eine Seitenfläche der ersten Stiftschicht (403) und mindestens einen Teil einer Seitenfläche des Chips (402) bedeckt, und das Formteil (404) an der Seitenfläche des Chips (402) angebracht ist; und
eine wasserdichte Schicht (405), die auf der zweiten Fläche (402b) des Chips (402) und der Fläche das Formteils (404), die vom Substrat (401) weg weist, angeordnet ist;
wobei die Chipgehäusestruktur (400) ferner Folgendes umfasst:
ein Stützteil (501a), das auf dem Substrat (401) angeordnet ist, wobei das Stützteil (501a) das Formteil (404) umgibt und eine äußere Seitenfläche des Formteils (404) an einer inneren Seitenfläche des Stützteils (501a) angebracht ist, wobei eine Fläche das Stützteils (501a), die vom Substrat (401) weg weist, höher ist als die zweite Fläche (402b) des Chips (402).

2. Chipgehäusestruktur (400) nach Anspruch 1, wobei das Formteil (404) alle Seitenflächen des Chips (402) bedeckt und die Fläche des Formteils (404), die vom Substrat (401) weg weist, bündig mit der zweiten Fläche (402b) des Chips (402) abschließt.

3. Chipgehäusestruktur (400) nach Anspruch 1, wobei die Fläche des Formteils (404), die vom Substrat (401) weg weist, tiefer ist als die zweite Fläche (402b) des Chips (402).

4. Chipgehäusestruktur (400) nach einem der Ansprüche 1 bis 3, ferner umfassend:
eine Kühlvorrichtung (101, 601), die einen Flüssigkeitseinlass (101a, 601a), eine Flüssigkeitsrücklauföffnung (101c, 601b) und einen sprinklerförmigen Strömungskanal (101b, 601c) umfasst, wobei ein Aufnahmehohlraum (107, 604) zum Aufnehmen eines Kühlmittels zwischen dem sprinklerförmigen Strömungskanal (101b, 601c), der Flüssigkeitsrücklauföffnung (101c, 601b) und der wasserdichten Schicht (405) gebildet ist, der Aufnahmehohlraum (107, 604) mindestens die wasserdichte Schicht (405) bedeckt, die der zweiten Fläche (402b) des Chips (402) entspricht, der Flüssigkeitseinlass (101a, 601a) in Verbindung mit dem sprinklerförmigen Strömungskanal (101b, 601c) steht, der sprinklerförmige Strömungskanal (101b, 601c) in Verbindung mit dem Aufnahmehohlraum steht (107, 604) und der Aufnahmehohlraum (107, 604) in Verbindung mit der Flüssigkeitsrücklauföffnung (101c, 601b) steht.

5. Elektronische Vorrichtung, wobei die elektronische Vorrichtung eine Leiterplatte (103, 300) und mindestens eine Chipgehäusestruktur (400) nach einem der Ansprüche 1 bis 4 umfasst und die Chipgehäusestruktur (400) mit der Leiterplatte (103, 300) verbunden ist.

6. Chipverpackungsverfahren, wobei das Verfahren Folgendes umfasst:
Bilden eines Umschließungsdamms (501) an einem Umfang eines Chips (402) zum Begrenzen eines Formteils (404), wobei sich der Umschließungsdamm (501) auf einem Substrat (401) befindet;
Bilden des Formteils (404), das den Chip (402) umgibt, auf dem Substrat (401), wobei das Bilden des Formteils (404), das den Chip (402) umgibt, auf dem Substrat (401) Folgendes umfasst:
Bilden des Formteils (404) zwischen dem Umschließungsdamm (501) und dem Chip (402), und wobei der Umschließungsdamm (501) ein Stützteil (501a) ist und eine äußere Seitenfläche des Formteils (404) an einer inneren Seitenfläche des Stützteils (501a) angebracht ist, und wobei der Chip (402) auf dem Substrat (401) angeordnet ist, der Chip (402) eine erste Fläche (402a) nahe dem Substrat (401) und eine zweite Fläche (402b) gegenüber der ersten Fläche (402a) aufweist, die erste Fläche (402a) durch eine erste Stiftschicht (403) mit dem Substrat (401) verbunden ist, die erste Stiftschicht (403) eine Vielzahl von Stiften umfasst, die zwischen der ersten Fläche (402a) des Chips (402) und dem Substrat (401) angeordnet ist, eine Fläche des Formteils (404), die vom Substrat (401) weg weist, höher ist als die erste Fläche (402a) des Chips (402), das Formteil (404) eine Seitenfläche der ersten Stiftschicht (403) und mindestens einen Teil einer Seitenfläche des Chips (402) bedeckt und das Formteil (404) an der Seitenfläche des Chips (402) angebracht ist, und wobei eine Fläche des Stützteils (501a), die vom Substrat (401) weg weist, höher ist als die zweite Fläche (402b) des Chips (402); und
Bilden einer wasserdichten Schicht (405) auf der zweiten Fläche (402b) des Chips (402) und der Fläche des Formteils (404), die vom Substrat (401) weg weist.

7. Chipverpackungsverfahren nach Anspruch 6, wobei das Formteil (404) alle Seitenflächen des Chips (402) bedeckt und die Fläche des Formteils (404), die vom Substrat (401) weg weist, bündig mit der zweiten Fläche (402b) des Chips (402) abschließt.

8. Chipverpackungsverfahren nach Anspruch 6, wobei die Fläche des Formteils (404), die vom Substrat (401) weg weist, tiefer ist als die zweite Fläche (402b) des Chips (402).

9. Chipverpackungsverfahren nach einem der Ansprüche 6 bis 8, wobei das Verfahren vor dem Formen eines Formteils (404), das einen Chip (402) umgibt, auf einem Substrat (401) ferner Folgendes umfasst:
Verbinden des Substrats (401) mit einer Leiterplatte (103, 300).

10. Chipverpackungsverfahren nach einem der Ansprüche 6 bis 8, wobei das Verfahren nach dem Bilden einer wasserdichten Schicht (405) auf der zweiten Fläche (402b) des Chips (402) und der Fläche des Formteils (404), die vom Substrat (401) weg weist, ferner Folgendes umfasst:
Verbinden des Substrats (401) mit einer Leiterplatte (103, 300).

## Revendications

1. Structure d'encapsulation de puce (400), comprenant :
un substrat (401) ;
une puce (402), ayant une première surface (402a) proche du substrat (401) et une seconde surface (402b) opposée à la première surface (402a) ;
une première couche de broches (403), comprenant une pluralité de broches disposées entre la première surface (402a) de la puce (402) et le substrat (401) ;
une pièce de moulage (404), disposée sur une périphérie de la puce (402) et de la première couche de broches (403), dans laquelle une surface qui fait partie de la pièce de moulage (404) et qui est éloignée du substrat (401) est plus haute que la première surface (402a) de la puce (402), et recouvre une surface latérale de la première couche de broches (403) et au moins une partie d'une surface latérale de la puce (402), et la pièce de moulage (404) est fixée à la surface latérale de la puce (402) ; et
une couche imperméable (405), disposée sur la seconde surface (402b) de la puce (402) et la surface qui fait partie de la pièce de moulage (404) et qui est éloignée du substrat (401) ;
dans laquelle la structure d'encapsulation de puce (400) comprend également :
une partie de support (501a), disposée sur le substrat (401), dans laquelle la partie de support (501a) entoure la pièce de moulage (404), et une surface latérale externe de la pièce de moulage (404) est fixée à une surface latérale interne de la partie de support (501a), dans laquelle une surface qui fait partie de la partie de support (501a) et qui est éloignée du substrat (401) est plus haute que la seconde surface (402b) de la puce (402).

2. Structure d'encapsulation de puce (400) selon la revendication 1, dans laquelle la pièce de moulage (404) recouvre toutes les surfaces latérales de la puce (402), et la surface qui fait partie de la pièce de moulage (404) et qui est éloignée du substrat (401) affleure la seconde surface (402b) de la puce (402).

3. Structure d'encapsulation de puce (400) selon la revendication 1, dans laquelle la surface qui fait partie de la pièce de moulage (404) et qui est éloignée du substrat (401) est plus basse que la seconde surface (402b) de la puce (402).

4. Structure d'encapsulation de puce (400) selon l'une quelconque des revendications 1 à 3, comprenant également :
un appareil de réfrigération (101, 601), comprenant une entrée de liquide (101a, 601a), un orifice de retour de liquide (101c, 601b) et un canal d'écoulement en forme de gicleur (101b, 601c), dans laquelle une cavité de logement (107, 604) destinée à loger un réfrigérant est formée entre le canal d'écoulement en forme de gicleur (101b, 601c), l'orifice de retour de liquide (101c, 601b) et la couche imperméable (405), la cavité de logement (107, 604) recouvre au moins la couche imperméable (405) correspondant à la seconde surface (402b) de la puce (402), l'entrée de liquide (101a, 601a) est en communication avec le canal d'écoulement en forme de gicleur (101b, 601c), le canal d'écoulement en forme de gicleur (101b, 601c) est en communication avec la cavité de logement (107, 604), et la cavité de logement (107, 604) est en communication avec l'orifice de retour de liquide (101c, 601b).

5. Dispositif électronique, dans lequel le dispositif électronique comprend une carte de circuit imprimé (103, 300) et au moins une structure d'encapsulation de puce (400) selon l'une quelconque des revendications 1 à 4, et la structure d'encapsulation de puce (400) est connectée à la carte de circuit imprimé (103, 300).

6. Procédé d'encapsulation de puce, dans lequel le procédé comprend :
la formation, sur une périphérie d'une puce (402), d'un barrage d'enceinte (501) pour limiter une pièce de moulage (404), dans lequel le barrage d'enceinte (501) est situé sur un substrat (401) ;
la formation, sur le substrat (401), de la pièce de moulage (404) qui entoure la puce (402), dans lequel la formation, sur le substrat (401), de la pièce de moulage (404) qui entoure la puce (402) comprend : la formation de la pièce de moulage (404) entre le barrage d'enceinte (501) et la puce (402), et dans lequel le barrage d'enceinte (501) est une partie de support (501a), et une surface latérale externe de la pièce de moulage (404) est fixée à une surface latérale interne de la partie de support (501a), et dans lequel la puce (402) est disposée sur le substrat (401), la puce (402) a une première surface (402a) proche du substrat (401) et une seconde surface (402b) opposée à la première surface (402a), la première surface (402a) est reliée au substrat (401) par l'intermédiaire d'une première couche de broches (403), la première couche de broches (403) comprend une pluralité de broches disposées entre la première surface (402a) de la puce (402) et le substrat (401), une surface qui fait partie de la pièce de moulage (404) et qui est éloignée du substrat (401) est plus haute que la première surface (402a) de la puce (402), la pièce de moulage (404) recouvre une surface latérale de la première couche de broches (403) et au moins une partie d'une surface latérale de la puce (402), et dans lequel la pièce de moulage (404) est fixée à la surface latérale de la puce (402), et dans lequel une surface qui fait partie de la partie de support (501a) et qui est éloignée du substrat (401) est plus haute que la seconde surface (402b) de la puce (402) ; et
la formation d'une couche imperméable (405) sur la seconde surface (402b) de la puce (402) et la surface qui fait partie de la pièce de moulage (404) et qui est éloignée du substrat (401) .

7. Procédé d'encapsulation de puce selon la revendication 6, dans lequel la pièce de moulage (404) recouvre toutes les surfaces latérales de la puce (402), et la surface qui fait partie de la pièce de moulage (404) et qui est éloignée du substrat (401) affleure la seconde surface (402b) de la puce (402) .

8. Procédé d'encapsulation de puce selon la revendication 6, dans lequel la surface qui fait partie de la pièce de moulage (404) et qui est éloignée du substrat (401) est plus basse que la seconde surface (402b) de la puce (402).

9. Procédé d'encapsulation de puce selon l'une quelconque des revendications 6 à 8, dans lequel, avant la formation, sur un substrat (401), d'une pièce de moulage (404) qui entoure une puce (402), le procédé comprend également :
la connexion du substrat (401) à une carte de circuit imprimé (103, 300).

10. Procédé d'encapsulation de puce selon l'une quelconque des revendications 6 à 8, dans lequel, après la formation d'une couche imperméable (405) sur la seconde surface (402b) de la puce (402) et la surface qui fait partie de la pièce de moulage (404) et qui est éloignée du substrat (401), le procédé comprend également :
la connexion du substrat (401) à une carte de circuit imprimé (103, 300).
